# EUROPEAN PATENT APPLICATION

(11) **EP 4 621 837 A1**
(43) Date of publication of application: **24.09.2025**
(21) Application number: 25161317.0
(22) Date of filing: 03.03.2025
(51) Int. Cl.: H01L 21/687

(54) **SUBSTRATE HOLDING DEVICE AND SUBSTRATE PROCESSING APPARATUS**

(30) Priority: 22.03.2024 JP 2024047222
(71) Applicant: SCREEN Holdings Co., Ltd., Kyoto-shi, Kyoto 602-8585 (JP)
(72) Inventor: TONAI, Hirofumi, Kyoto, 602-8585 (JP)
(74) Representative: Kilian Kilian & Partner mbB

(57) **Abstract**

A spin chuck has a spin base. Fixed holders and mobile holders are provided in a peripheral portion of the spin base. Each mobile holder is provided to be changeable to a holding state in which the mobile holder comes into contact with the outer peripheral end of a substrate arranged on the spin base and a releasing state in which the mobile holder is spaced apart from the substrate. A magnet lifting-lowering device is configured to be capable of switching the state of each mobile holder using a lifting-lowering magnet. A controller selectively executes a first control and a second control. In the first control, the controller switches the states of all of the mobile holders at the same time. In the second control, the controller switches the states of one mobile holder and another mobile holder at different points in time.

## Description

### BACKGROUND

### Technical Field

The present disclosure relates to a substrate holding device that holds a substrate, and a substrate processing apparatus.

### Description of Related Art

A substrate processing apparatus is used to execute various processes on a substrate such as a semiconductor substrate, a substrate for an FPD (Flat Panel Display) that is used for a liquid crystal display device, an organic EL (Electro Luminescence) display device or the like, a substrate for an optical disc, a substrate for a magnetic disc, a substrate for a magneto-optical disc, a substrate for a photomask, a ceramic substrate or a substrate for a solar cell. In a single-wafer substrate processing apparatus that processes substrates one by one, a substrate holding device for holding a substrate to be processed is used.

For example, a substrate processing apparatus described in JP 2022-86362 A includes a chuck unit that holds a substrate in a horizontal posture as a substrate holding device. The chuck unit includes a flat rotation table having a circular shape in plan view, and two fixed pins and two mobile pins for holding the outer peripheral end of the substrate on the rotation table. The two fixed pins and the two mobile pins are arranged at equal intervals in the peripheral portion of the rotation table such that a fixed pin and a mobile pin are opposite to each other with the center of the rotation table provided therebetween in plan view.

The mobile pin is configured to be switchable, by a switching mechanism, between a state in which the substrate can be held and a state in which the substrate can be received and transferred. Thus, when each mobile pin is in the state in which the substrate can be received and transferred, the substrate can be arranged between the two fixed pins and the two mobile pins. Further, when the substrate is arranged between the two fixed pins and the two mobile pins, each mobile pin is switched to a state in which the substrate can be held. Thus, the substrate is held.

### SUMMARY

The mobile pin switching mechanism described in JP 2022-86362 A is configured to switch the states of the two mobile pins at the same time. In this case, as compared to a case in which the states of the two mobile pins are switched individually, a period of time required until the substrate is held since the substrate is arranged between the two fixed pins and the two mobile pins is shortened.

Incidentally, a cutout such as a notch or an orientation flat is provided in a portion of the outer peripheral end of the substrate for identification of a crystal orientation of the substrate or positioning of the substrate in accordance with a predetermined condition. Therefore, when one of the two mobile pins is fitted into the notch of the substrate, the outer peripheral end of the substrate may not be held by all of the pins (four pins) due to the two mobile pins abutting against the outer peripheral end of the substrate with a minute time difference. That is, the outer peripheral end of the substrate may be held by three pins. The holding of the substrate by the three pins is not allowed depending on the processing contents for the substrate.

An object of the present disclosure is to provide a substrate holding device and a substrate processing apparatus capable of appropriately holding a substrate in accordance with processing contents for the substrate.

A substrate holding device according to one aspect of the present disclosure that holds a substrate, includes a support that supports the substrate, a rotation member provided to be rotatable about an axis extending in an upward-and-downward direction, a rotation driver that rotates the rotation member about the axis, a plurality of mobile holders that are provided in a peripheral portion of the rotation member, with each mobile holder being switchable between a holding state in which the mobile holder abuts against an outer peripheral end of the substrate to hold the substrate and a releasing state in which the mobile holder is spaced apart from the outer peripheral end of the substrate, a state switcher that switches the plurality of mobile holders between the holding state and the releasing state, and a controller that selectively executes a first control and a second control with respect to the state switcher, wherein in the first control, the plurality of mobile holders are switched from the releasing state to the holding state at a same time, and in the second control, switching of part of the plurality of mobile holders from the releasing state to the holding state and switching of other mobile holders of the plurality of mobile holders from the releasing state to the holding state are executed at different points in time.

A substrate processing apparatus according to another aspect of the present disclosure includes the above-mentioned substrate holding device that holds a substrate, and a processor that executes a predetermined process on the substrate held and rotated by the substrate holding device.

With the present disclosure, it is possible to appropriately hold a substrate in accordance with the processing contents for the substrate.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a schematic side view showing the basic configuration of a substrate processing apparatus according to a first embodiment;
Fig. 2 is a schematic plan view of the substrate processing apparatus of Fig. 1;
Fig. 3 is an external perspective view of magnet lifting-lowering devices as viewed through a spin base from a position above a fixed holder of Fig. 2;
Fig. 4 is a diagram for explaining a switching function of the magnet lifting-lowering devices of Fig. 3;
Fig. 5 is a block diagram showing the configuration of a control system of the substrate processing apparatus of Fig. 1;
Fig. 6 is a flowchart showing one example of a substrate holding process according to the first embodiment;
Fig. 7 is a schematic plan view showing, in time series, the transition of a state of a substrate and a state of a spin chuck when the substrate holding process of Fig. 6 is executed;
Fig. 8 is a schematic plan view showing, in time series, the transition of the state of the substrate and the state of the spin chuck when the substrate holding process of Fig. 6 is executed;
Fig. 9 is a schematic plan view of a substrate processing apparatus according to a second embodiment;
Fig. 10 is a diagram showing a control system of the substrate processing apparatus according to the second embodiment; and
Fig. 11 is a flowchart showing one example of a substrate holding process according to the second embodiment.

### DETAILED DESCRIPTION

A substrate holding device and a substrate processing apparatus according to one embodiment of the present disclosure will be described below with reference to the drawings. In the following description, a substrate refers to a substrate for an FPD (Flat Panel Display) that is used for a liquid crystal display device, an organic EL (Electro Luminescence) display device or the like, a semiconductor substrate, a substrate for an optical disc, a substrate for a magnetic disc, a substrate for a magneto-optical disc, a substrate for a photomask, a ceramic substrate, a substrate for a solar cell or the like. A substrate described below is a substrate that is at least partially circular and is a circular substrate in which a notch for positioning is formed at a portion of the outer peripheral end. The length of the notch in a circumferential direction of the substrate is not less than 2.62 mm and not more than 3.76 mm, for example.

### 1. First Embodiment

### <1> Basic Configuration of Substrate Processing Apparatus

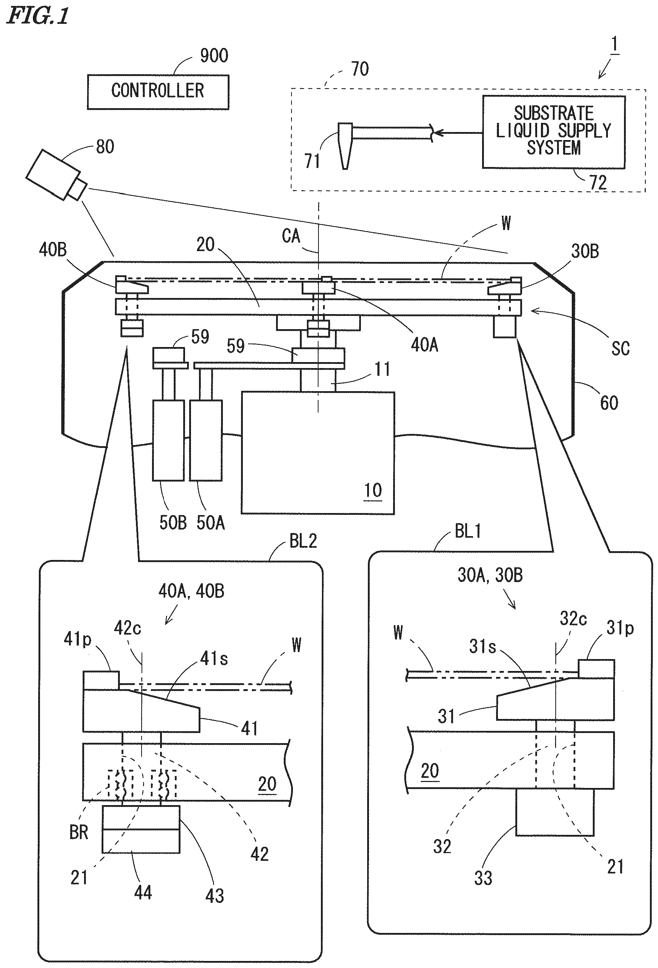

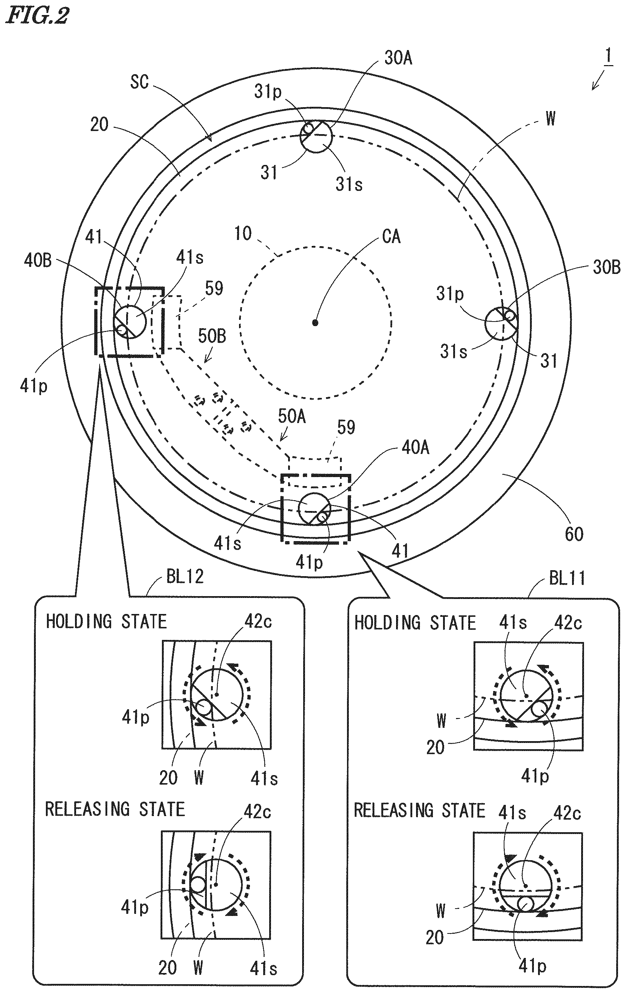

Fig. 1 is a schematic side view showing the basic configuration of a substrate processing apparatus according to a first embodiment. Fig. 2 is a schematic plan view of the substrate processing apparatus 1 of Fig. 1. In Fig. 2, some constituent elements (a controller 900, a processing liquid supply device 70 and an imaging device 80, described below) out of a plurality of constituent elements shown in Fig. 1 are not shown.

As shown in Figs. 1 and 2, the substrate processing apparatus 1 according to the first embodiment includes a rotation driver 10, a spin base 20, two fixed holders 30A, 30B, two mobile holders 40A, 40B, two magnet lifting-lowering devices 50A, 50B, a cup 60, the processing liquid supply device 70, the imaging device 80 and a controller 900. These respective constituent elements are accommodated in a chamber (not shown), for example.

The rotation driver 10 is a motor, for example, and is fixed to the bottom portion of the chamber. The rotation driver 10 has a rotation shaft 11 extending upwardly. A center axis CA of the rotation shaft 11 extends in an upward-and-downward direction. The spin base 20 is connected to the upper end portion of the rotation shaft 11. The spin base 20 has a disc shape and is rotatably supported in a horizontal posture by the rotation shaft 11.

As shown in Fig. 2, the two fixed holders 30A, 30B and the two mobile holders 40A, 40B are attached to the peripheral portion of the spin base 20. Further, the fixed holder 30A, the fixed holder 30B, the mobile holder 40A and the mobile holder 40B are arranged in this order so as to be arranged in a clockwise direction along the outer peripheral end of the spin base 20 in plan view. In the substrate processing apparatus 1, a so-called spin-chuck is formed of an assembly of the spin base 20, the two fixed holders 30A, 30B and the two mobile holders 40A, 40B. In the following description, the assembly of the spin base 20, the two fixed holders 30A, 30B and the two mobile holders 40A, 40B is suitably referred to as the spin chuck SC. In each of Figs. 1 and 2, the substrate W held by the spin chuck SC is indicated by the two-dots and dash line. In regard to the substrate W shown in Fig. 1 and subsequent drawings, a notch is not shown.

The two fixed holders 30A, 30B have the same configuration. In Fig. 1, an enlarged side view of the fixed holders 30A, 30B is shown in the balloon BL1. As shown in the balloon BL1, each of the fixed holders 30A, 30B mainly includes a support 31, a shaft portion 32 and a shaft fixing member 33.

Four through holes 21 extending in the upward-and-downward direction are respectively provided in attachment portions for the four holders (30A, 30B, 40A, 40B) of the spin base 20. Each through hole 21 has a circular shape in plan view. The shaft portion 32 of each of the fixed holders 30A, 30B is a bar-shaped member having a circular cross section, and has an outer diameter slightly smaller than the inner diameter of the through hole 21. The shaft portion 32 is inserted into the through hole 21 so as to penetrate the spin base 20.

On the upper surface of the spin base 20, the support 31 is attached and fixed to the upper end portion of the shaft portion 32. As shown in Fig. 2, the support 31 of each of the fixed holders 30A, 30B has a circular shape in plan view. As shown in the balloon BL1 of Fig. 1, the support 31 has a flat inclined surface 31s slightly inclined with respect to a horizontal plane. The inclined surface 31s is configured to be capable of supporting the outer peripheral end and the peripheral portion of the lower surface of the substrate W from below. Further, the support 31 has a pin 31p that further projects upwardly from an upper end portion of the inclined surface 31s. The pin 31p is located at a position spaced apart from a center axis 32c of the shaft portion 32 with the support 31 being attached to the shaft portion 32. The pin 31p is formed to have a cylindrical shape, and has the diameter of not less than 2.50 mm and not more than 6.00 mm, for example.

On the lower surface of the spin base 20, the shaft fixing member 33 is attached and fixed to the lower end portion of the shaft portion 32. The shaft fixing member 33 is further fixed to the lower surface of the spin base 20. In this state, the pin 31p of the support 31 is located farther outwardly of the spin base 20 than the center axis 32c of the shaft portion 32.

The two mobile holders 40A, 40B have the same configuration. In Fig. 1, an enlarged side view of the mobile holders 40A, 40B is shown in the balloon BL2. As shown in the balloon BL2, each of the mobile holders 40A, 40B mainly includes a support 41, a shaft portion 42, a magnet coupling member 43 and a magnet 44. The shaft portion 42 of each of the mobile holders 40A, 40B is a bar-shaped member having a circular cross section and is inserted into the through hole 21 so as to penetrate the spin base 20.

On the upper surface of the spin base 20, the support 41 is attached and fixed to the upper end portion of the shaft portion 42. The support 41 has the same shape as the support 31 of each of the fixed holders 30A, 30B. That is, the support 41 has a flat inclined surface 41s slightly inclined with respect to the horizontal plane. The inclined surface 41s is configured to be capable of supporting the outer peripheral end and the peripheral portion of the lower surface of the substrate W from below. Further, the support 41 has a pin 41p that further projects upwardly from an upper end portion of the inclined surface 41s. The pin 41p is located at a position spaced apart from a center axis 42c of the shaft portion 42 with the support 41 being attached to the shaft portion 42.

Here, a bearing BR is provided between the shaft portion 42 of each of the mobile holders 40A, 40B and the inner peripheral surface of the through hole 21 of the spin base 20. The bearing BR supports the shaft portion 42 arranged in the through hole 21 so as to be rotatable about the center axis 42c of the shaft portion 42 with respect to the inner peripheral surface of the through hole 21. Further, the bearing BR supports the shaft portion 42 arranged in the through hole 21 such that the shaft portion 42 is not mobile in the direction in which the center axis 42c extends (the upward-and-downward direction) with respect to the inner peripheral surface of the through hole 21.

On the lower surface of the spin base 20, the magnet 44 is attached and fixed to the lower end portion of the shaft portion 42 via the magnet coupling member 43. The magnet 44 is held with an N pole and an S pole being arranged in the horizontal plane.

In the peripheral portion of the magnet 44, a plurality of constituent elements (a holding magnet 45 and magnet lifting-lowering devices 50A, 50B, described below) that cause a magnetic field to be exerted on the magnet 44 from the outside and adjust the direction of the magnetic field to be exerted on the magnet 44 are provided. By adjusting the direction of the magnetic field to be exerted on the magnet 44, it is possible to rotate the support 41 about the center axis 42c of the shaft portion 42.

For example, the substrate W is placed on the inclined surfaces 31s, 41s of the four holders (30A, 30B, 40A, 40B). In this state, as shown in the upper field of each of the balloons BL11 and BL12 extending from the frame of the thick one-dot and dash line in Fig. 2, the support 41 of each of the mobile holders 40A, 40B rotates in a counterclockwise direction in plan view. In this case, the substrate W on the four supports 31, 41 is held so as to be interposed by the four pins 31p, 41p. The state of the mobile holders 40A, 40B when the spin chuck SC holds the substrate W in this manner is referred to as a holding state. In the holding state, the mobile holders 40A, 40B abut against the outer peripheral end of the substrate W to hold the substrate W.

On the other hand, as shown in the lower field of each of the balloons BL11 and BL12 in Fig. 2, with the substrate W held by the spin chuck SC, for example, the support 41 of each of the mobile holders 40A, 40B rotates in the clockwise direction in plan view. In this case, the two pins 41p out of the four pins 31p, 41p are spaced apart from the outer peripheral end of the substrate W. Thus, the substrate W released on the inclined surfaces 31s, 41s of the four supports 31, 41 can be taken out. The state of the mobile holders 40A, 40B when the spin chuck SC releases the substrate W in this manner is referred to as a releasing state.

As shown in Fig. 1, the magnet lifting-lowering devices 50A, 50B are fixed to the bottom portion of the chamber so as to respectively correspond to the mobile holders 40A, 40B. The magnet lifting-lowering devices 50A, 50B support two lifting-lowering magnets 59 respectively corresponding to the magnets 44 of the mobile holders 40A, 40B such that the lifting-lowering magnets 59 are liftable and lowerable at predetermined planar positions. The two lifting-lowering magnets 59 are used to adjust the direction of a magnetic field to be exerted on the magnets 44 of the mobile holders 40A, 40B and switch the states of the mobile holders 40A, 40B. In the following description, the function of the magnet lifting-lowering devices 50A, 50B for switching the states of the mobile holders 40A, 40B using the lifting-lowering magnet 59 is referred to as a switching function. The magnet lifting-lowering devices 50A, 50B and the switching function will be described in detail below.

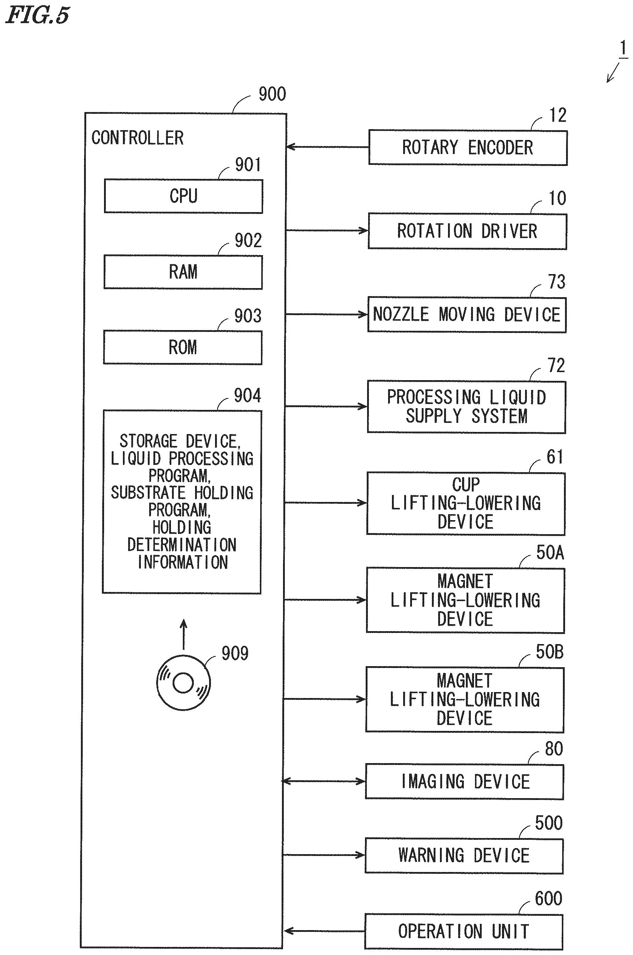

The cup 60 is provided so as to surround the rotation driver 10 and the spin base 20 in plan view. The cup 60 is provided to be mobile in the upward-and-downward direction between an upper cup position and a lower cup position by a cup lifting-lowering device 61 (Fig. 5), described below. The lower cup position is a height position (the position in the upward-and-downward direction) at which the upper end portion of the cup 60 is located farther downwardly than the spin chuck SC. Further, the upper cup position is a height position at which the upper end portion of the cup 60 is located farther upwardly than the substrate W held by the spin chuck SC.

During a process for the substrate W, a processing liquid is supplied from the processing liquid supply device 70, described below, to the substrate W held and rotated by the spin chuck SC. As such, the cup 60 is arranged at the upper cup position during the process for the substrate W. Thus, the cup 60 receives the processing liquid splashed from the rotating substrate W. On the other hand, the cup 60 is arranged at the lower cup position in a period during which the substrate W is not processed in the substrate processing apparatus 1.

The processing liquid supply device 70 includes a nozzle 71 and a processing liquid supply system 72. The processing liquid supply system 72 includes one or a plurality of fluid-related elements such as a pipe, a joint, a valve, a pump and a tank, and is connected to a processing liquid supply source. The processing liquid supply system 72 supplies the processing liquid from the processing liquid supply source to the nozzle 71.

The nozzle 71 is supported by a nozzle moving device 73 (Fig. 5), described below, so as to be mobile between a processing position above the spin chuck SC and a waiting position close to the spin chuck SC in the chamber of the substrate processing apparatus 1. With the nozzle 71 being arranged at the processing position, the processing liquid is supplied from the processing liquid supply system 72 to the nozzle 71. Thus, the processing liquid is discharged from the nozzle 71 to the substrate W, and the substrate W is processed.

The imaging device 80 is a camera, for example, and includes a plurality of lenses and a color CCD (charge coupled device) sensor. The imaging device 80 picks up an image of the entire substrate W held by the spin chuck SC from a position obliquely above the spin chuck SC. At this time, the imaging device 80 picks up images of the pins 31p, 41p of the plurality of holders (30A, 30B, 40A, 40B) in addition to the substrate W. The controller 900 controls the work of each component of the above-mentioned substrate processing apparatus 1. Details of the controller 900 will be described below.

### <2> Magnet Lifting-Lowering Devices 50A, 50B

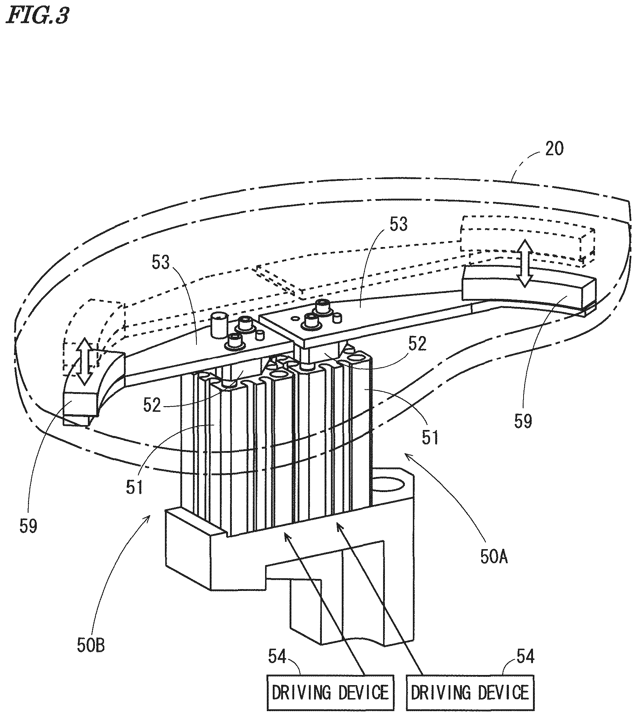

Fig. 3 is an external perspective view of the magnet lifting-lowering devices 50A, 50B as viewed through the spin base 20 from a position above the fixed holder 30B of Fig. 2. In Fig. 3, part of the spin base 20 is indicated by the one-dot and dash lines. The plurality of holders (30A, 30B, 40A, 40B) are not shown.

As shown in Fig. 3, the magnet lifting-lowering device 50A includes an air cylinder 51, a lifting-lowering shaft 52, a support plate 53, a driving device 54 and a lifting-lowering magnet 59. The air cylinder 51 is attached to the chamber via a bracket.

The lifting-lowering shaft 52 is provided so as to extend upwardly from a piston provided in the air cylinder 51. The support plate 53 is attached to the upper end portion of the lifting-lowering shaft 52. The support plate 53 is a plate member processed into a predetermined shape, and extends in one direction in a horizontal plane from the upper end portion of the lifting-lowering shaft 52.

The lifting-lowering magnet 59 is provided at the tip of the support plate 53. As shown in Fig. 2, the lifting-lowering magnet 59 is held at a position spaced apart from the outer peripheral end of the spin base 20 toward the center axis CA by a predetermined distance in plan view. The predetermined distance is slightly larger than the diameter of the support 41.

The driving device 54 of Fig. 3 includes a pump or an electropneumatic regulator, for example, and drives the air cylinder 51. Specifically, the pressure of air supplied into the air cylinder 51 is adjusted by the driving device 54. Thus, the lifting-lowering shaft 52 moves upwardly and downwardly together with the piston in the air cylinder 51, and the height position of the lifting-lowering magnet 59 is adjusted to an upper magnet position or a lower magnet position. The lower magnet position is a position farther downwardly than the magnet 44 of the mobile holder 40A by a certain distance. The upper magnet position is the same height position as that of the magnet 44 of the mobile holder 40A.

The magnet lifting-lowering device 50B basically has the same configuration as that of the magnet lifting-lowering device 50A, and is provided to be adjacent to the magnet lifting-lowering device 50A. As shown in Fig. 2, the position at which the lifting-lowering magnet 59 of the magnet lifting-lowering device 50B is held deviates by 90° in the circumferential direction of the spin base 20 with respect to the position of the lifting-lowering magnet 59 of the magnet lifting-lowering device 50A based on the center axis CA in plan view.

The magnet lifting-lowering devices 50A, 50B can work respectively and independently of each other. Therefore, the height position of the lifting-lowering magnet 59 of the magnet lifting-lowering device 50A and the height position of the lifting-lowering magnet 59 of the magnet lifting-lowering device 50B can be individually adjusted as indicated by the two outlined arrow in Fig. 3.

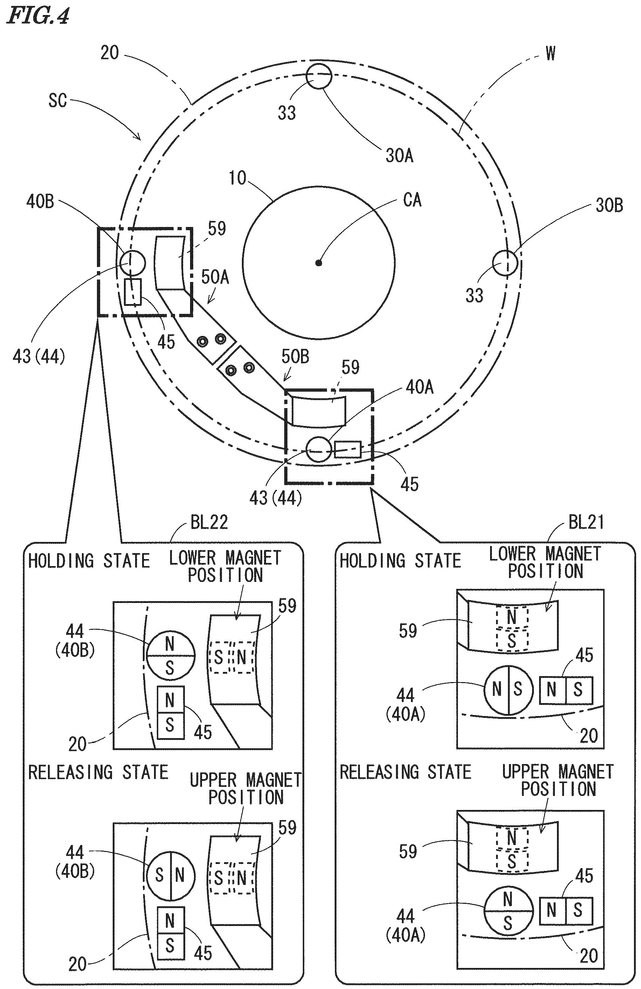

Fig. 4 is a diagram for explaining the switching function of the magnet lifting-lowering devices 50A, 50B of Fig. 3. Fig. 4 shows a schematic plan view of a plurality of constituent elements provided on the lower surface of the spin base 20, the magnet lifting-lowering devices 50A, 50B, and the rotation driver 10 as being viewed through the spin base 20 in plan view. In the present example, similarly to the examples of Figs. 1 and 2, the rotation position (rotation angle) of the spin chuck SC is adjusted such that the mobile holders 40A, 40B are respectively located in the vicinity of the lifting-lowering magnets 59 of the magnet lifting-lowering devices 50A, 50B in plan view.

In Fig. 4, the outer shape of the spin base 20 is indicated by the one-dot and dash line. Further, the outer shape of the substrate W held by the spin chuck SC is indicated by the two-dot and dash line. In Fig. 4, the cup 60 of Fig. 1 is not shown.

As shown in Fig. 4, in the lower surface of the spin base 20, the holding magnet 45 is attached to a position in the vicinity of the magnet 44 of each of the mobile holders 40A, 40B. The magnet 44 and the holding magnet 45 adjacent to each other are arranged in the circumferential direction of the spin base 20.

Here, as shown in the balloons BL21 and BL22 extending from the frame of the thick one-dot and dash line in Fig. 4, each of the holding magnets 45 is arranged such that an N pole and an S pole are arranged in this order in a direction away from the magnet 44 along the outer peripheral end of the spin base 20 in plan view. Further, the lifting-lowering magnet 59 of each of the magnet lifting-lowering devices 50A, 50B is arranged such that an N pole and an S pole are arranged in this order in a radial direction from the center of the spin base 20 toward the outer peripheral end of the spin base 20 in plan view.

As shown in each of the upper fields of the balloons BL21 and BL22, suppose that the lifting-lowering magnet 59 of each of the magnet lifting-lowering devices 50A, 50B is arranged at the lower magnet position. In this case, the lifting-lowering magnet 59 is located farther downwardly than the magnet 44 of each of the mobile holders 40A, 40B by a certain distance. That is, the lifting-lowering magnet 59 is spaced apart from the magnet 44 by a certain distance. Therefore, a magnetic field generated from the lifting-lowering magnet 59 is unlikely to be exerted on the magnet 44 of each of the mobile holders 40A, 40B. A magnetic field exerted on the magnet 44 is mainly generated from the holding magnet 45. Thus, the magnet 44 is held with the S pole directed toward the holding magnet 45. In a case in which the S pole of the magnet 44 is not directed toward the holding magnet 45, a rotational force is generated in the magnet 44 such that the S pole is directed toward the holding magnet 45.

On the other hand, as shown in the lower field of each of the balloons BL21 and BL22, suppose that the lifting-lowering magnet 59 of each of the magnet lifting-lowering devices 50A, 50B is arranged at the upper magnet position. In this case, the lifting-lowering magnet 59 is located at the same height position as that of the magnet 44 of each of the corresponding mobile holders 40A, 40B. That is, the lifting-lowering magnet 59 is on the same plane as that of the corresponding magnet 44 and the corresponding holding magnet 45. Further, the lifting-lowering magnet 59 is close to the magnet 44.

Thus, a magnetic field generated from the holding magnet 45 and a magnetic field generated from the lifting-lowering magnet 59 are exerted on the magnet 44 of each of the mobile holders 40A, 40B. Here, as the lifting-lowering magnet 59 according to the present embodiment, a magnet having a magnetic force sufficiently higher than that of the holding magnet 45 is used. Therefore, the magnet 44 is held with the N pole directed toward the lifting-lowering magnet 59 by being affected by the magnetic field generated from the lifting-lowering magnet 59. In a case in which the N pole of the magnet 44 is not directed toward the lifting-lowering magnet 59, a rotational force is generated in the magnet 44 such that the N pole is directed toward the lifting-lowering magnet 59.

The support 41 is attached onto the shaft portion 42 such that each of the mobile holders 40A, 40B is in the holding state when the S pole of the magnet 44 is directed toward the holding magnet 45 and is in the releasing state when the N pole of the magnet 44 is directed toward the lifting-lowering magnet 59 located at the upper magnet position.

As described above, each of the magnet lifting-lowering devices 50A, 50B can switch each of the mobile holders 40A, 40B from the holding state to the releasing state by moving the lifting-lowering magnet 59 from the lower magnet position to the upper magnet position. Further, each of the magnet lifting-lowering devices 50A, 50B can switch each of the mobile holders 40A, 40B from the releasing state to the holding state by moving the lifting-lowering magnet 59 from the upper magnet position to the lower magnet position.

### <3> Control System of Substrate Processing Apparatus 1

A control system of the substrate processing apparatus 1 will be described together with the configuration of the controller 900 of Fig. 1. Fig. 5 is a block diagram showing the configuration of the control system of the substrate processing apparatus 1 of Fig. 1. As shown in Fig. 5, the controller 900 includes a CPU (Central Processing Unit) 901, a RAM (Random Access Memory) 902, a ROM (Read Only Memory) 903 and a storage device 904. The RAM 902 is used as a work area for the CPU 901. A system program is stored in the ROM 903. The storage device 904 includes a storage medium such as a hard disc or a semiconductor memory and stores a liquid processing program. The liquid processing program of the present example is a program for supplying a processing liquid to the substrate W.

Further, the storage device 904 stores a substrate holding program. The substrate holding program is a program of a substrate holding process for causing the spin chuck SC to appropriately hold the substrate W. Details of the substrate holding process will be described below.

Further, the storage device 904 stores holding determination information for determining whether the substrate W is normally held by the spin chuck SC during the substrate holding process, described below. The holding determination information may include image data obtained when an image of the substrate W is picked up by the imaging device 80 with the substrate W being normally held by the spin chuck SC, for example.

Here, each of the liquid processing program and the substrate holding program of Fig. 5 may be provided in the state of being stored in a recording media such as a CD-ROM 909 and installed in the ROM 903 or the storage device 904. Alternatively, each of the liquid processing program and the substrate holding program may be distributed from a server outside of the substrate processing apparatus 1 via a communication network and installed in the ROM 903 or the storage device 904. The CPU 901 executes either one of the liquid processing program or the substrate holding program, thereby controlling the work of each component of the substrate processing apparatus 1.

In the rotation driver 10, a rotary encoder 12 that detects a rotation amount of a rotor (not shown) of the rotation driver 10 and outputs a signal indicating the rotation amount is provided. The controller 900 controls the rotation driver 10 based on the signal output from the rotary encoder 12. Thus, the spin chuck SC rotates at a predetermined speed. Further, the rotation position (rotation angle) of the spin chuck SC is adjusted.

Further, the controller 900 controls the nozzle moving device 73. Thus, the nozzle 71 of Fig. 1 moves between the processing position and the waiting position in the chamber. Further, the controller 900 controls the processing liquid supply system 72. Thus, the processing liquid is supplied to the nozzle 71 of Fig. 1.

Further, the controller 900 controls the cup lifting-lowering device 61. Thus, the cup 60 of Fig. 1 moves between the upper cup position and the lower cup position in accordance with the timing for receiving the substrate W from and transferring the substrate W to the spin chuck SC and the timing for supplying the processing liquid to the substrate W.

Further, the controller 900 controls the magnet lifting-lowering devices 50A, 50B. Thus, the state of each of the mobile holders 40A, 40B of the spin chuck SC is switched between the holding state and the releasing state. Further, the controller 900 controls the imaging device 80. Thus, an image of the substrate W immediately after being held by the spin chuck SC, for example, is picked up by the imaging device 80.

As shown in Fig. 5, the substrate processing apparatus 1 further includes a warning device 500 and an operation unit 600. The warning device 500 is an output device that outputs a warning. The warning device 500 may include a display device that displays an image for an occurrence of an abnormality, a warning lamp that makes notification of an occurrence of an abnormality, or a sound output device that outputs a speech making notification of an occurrence of an abnormality. The controller 900 controls the warning device 500. Thus, in a case in which an abnormality occurs in the spin chuck SC, for example, a warning is output from the warning device 500.

The operation unit 600 includes a keyboard and a pointing device, and is configured to be operable by a user. The user can set various work conditions of the substrate processing apparatus 1 by operating the operation unit 600.

### <4> Substrate Holding Process

In the following description, as shown in Figs. 2 and 4, the rotation position of the spin chuck SC when the mobile holders 40A, 40B are respectively located in the vicinities of the lifting-lowering magnets 59 of the magnet lifting-lowering devices 50A, 50B in plan view is referred to as a reference position. Further, a counter is built in the controller 900.

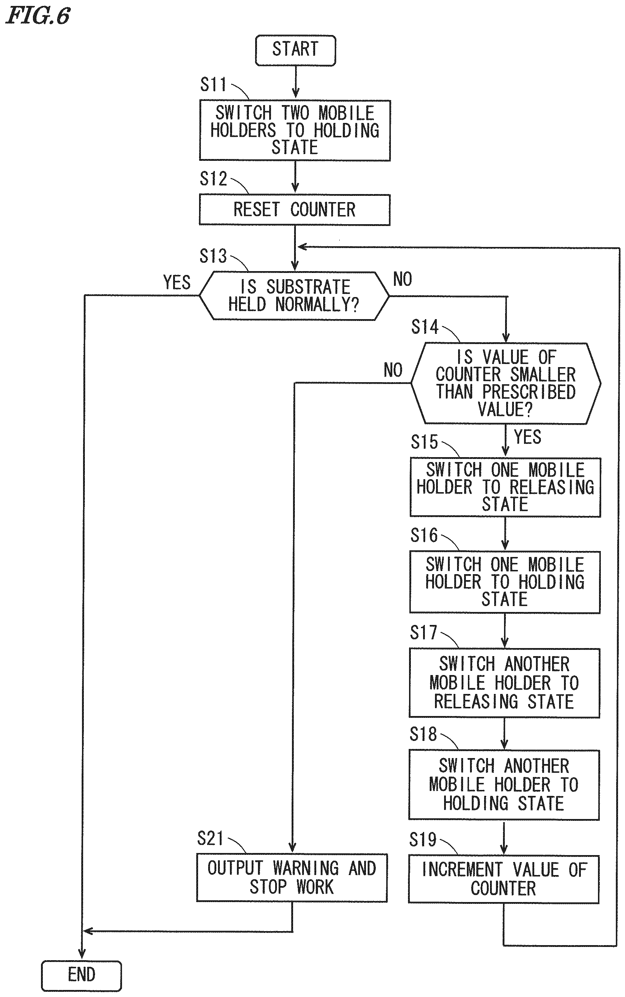

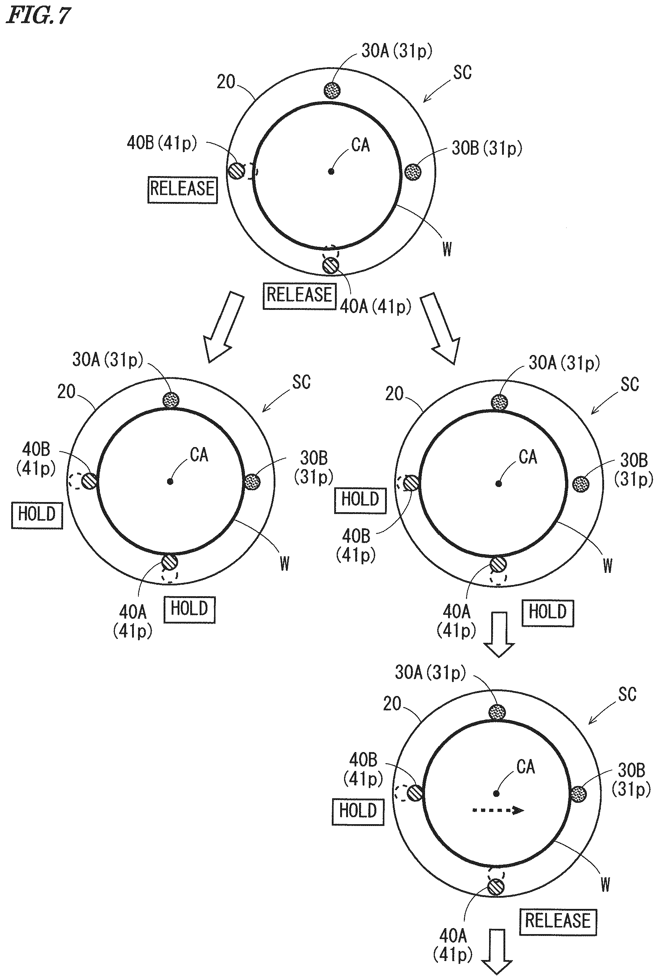

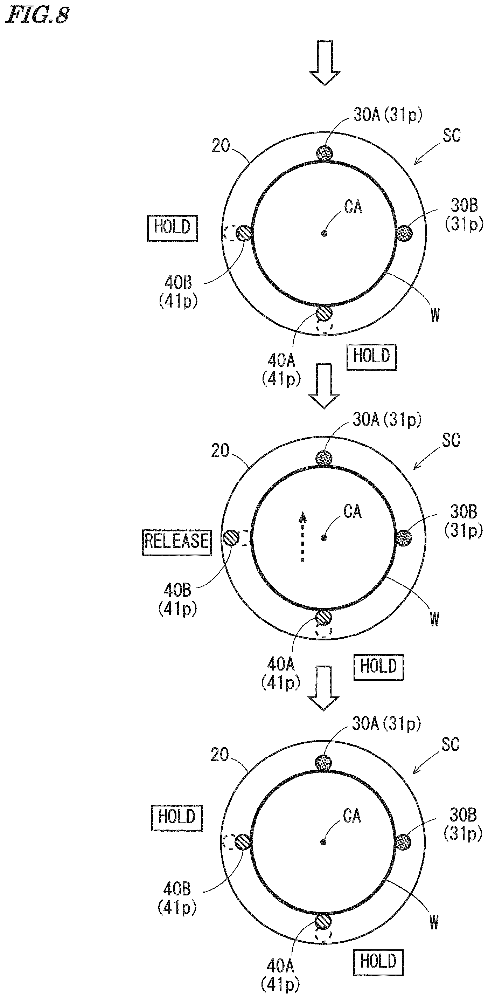

Fig. 6 is a flowchart showing one example of a substrate holding process according to the first embodiment. Figs. 7 and 8 are schematic plan views showing, in time series, the transition of the state of the substrate W and the spin chuck SC when the substrate holding process of Fig. 6 is executed. In each of the schematic plan views of Figs. 7 and 8, only the pins 31p, 41p of the fixed holders 30A, 30B and the mobile holders 40A, 40B are shown in an exaggerated manner.

As described above, the substrate holding process is a process for causing the spin chuck SC to appropriately hold the substrate W. This process is executed when the CPU 901 of the controller 900 executes the substrate holding program stored in the storage device 904 in response to placement of the substrate W on the spin chuck SC, for example.

In an initial state, the rotation position of the spin chuck SC is adjusted to the reference position. Further, each of the magnet lifting-lowering devices 50A, 50B holds the lifting-lowering magnet 59 at the upper magnet position. Thus, the mobile holders 40A, 40B are both in the releasing state. Further, as shown in the upper field of Fig. 7, the substrate W is placed on the spin chuck SC. Specifically, the substrate W is supported by four supports 31, 41. In the example of the upper field of Fig. 7, none of the pins 31p, 41p of the four holders (30A, 30B, 40A, 40B) abuts against the outer peripheral end of the substrate W.

When the substrate holding process is started, the controller 900 switches the two mobile holders 40A, 40B from the releasing state to the holding state by controlling the magnet lifting-lowering devices 50A, 50B (step S11). Specifically, the controller 900 lowers each of the two lifting-lowering magnets 59 of the magnet lifting-lowering devices 50A, 50B from the upper magnet position to the lower magnet position. Thus, the two mobile holders 40A, 40B are switched from the releasing state to the holding state.

In this case, as shown in the middle left field of Fig. 7, for example, the substrate W is interposed between the two pins 31p, 41p of the fixed holder 30A and the mobile holder 40A that are opposite to each other. Further, the substrate W is interposed between the two pins 31p, 41p of the fixed holder 30B and the mobile holder 40B that are opposite to each other. In this manner, in a case in which the substrate W is held with the total of the four pins 31p, 41p abutting against the outer peripheral end of the substrate W, the holding state of the substrate W is considered to be normal (four-point of support).

However, when the two mobile holders 40A, 40B are switched from the releasing state to the holding state as described above, in a case in which one of the two pins 41p is fitted into a notch of the substrate W, the two pins 41p abut against the substrate W at different points in time. In this case, when the one pin 41p abuts against the substrate W, the substrate W is interposed between the pin 41p and the pin 31p opposite to the pin 41p, and then the other pin 41p is fitted into the notch of the substrate W. Thus, even when the other pin 41p pushes the substrate W toward the pin 31p opposite to the pin 41p, the substrate W might not move. In this case, as shown in the middle right of Fig. 7, the substrate W is held by the two pins 41p and the one pin 31p (three-point of support). As such, in the substrate holding process according to the first embodiment, the work for holding the substrate W is performed again when the substrate W is supported at three points as described above. Further, whether the substrate W is supported at the three points due to an abnormality (failure or the like) of the substrate processing apparatus 1 is determined.

Specifically, after the above-mentioned step S11, the controller 900 resets a value of a counter (step S12). Further, the controller 900 determines whether the substrate W is normally held on the spin chuck SC (step S13). In the present embodiment, the step S13 is performed as follows, for example.

First, an image of the substrate W held on the spin chuck SC is picked up by the imaging device 80 of Fig. 1. Thus, the image data representing the images of the substrate W and the plurality of holders (30A, 30B, 40A, 40B) is generated. Thereafter, the generated image data is compared with the holding determination information stored in the storage device 904, and a difference is detected. As described above, the holding determination information includes image data obtained when an image of the substrate W is picked up by the imaging device 80 with the substrate W being normally held by the spin chuck SC, for example. Thus, based on the magnitude of the detected difference, whether the substrate W is normally held on the spin chuck SC is determined.

Based on the image data obtained by imaging, the controller 900 may make the above-mentioned determination in regard to whether there is a gap between one of the plurality of pins 31p and the substrate W.

In a case in which the substrate W is normally held on the spin chuck SC in the step S13, the substrate holding process ends. On the other hand, in a case in which the substrate W is not normally held on the spin chuck SC, the controller 900 determines whether a value of the counter is smaller than a predetermined prescribed value (step S14). Here, the prescribed value is a value set by the user who uses the operation unit 600 in order to determine an abnormality of the substrate processing apparatus 1. In the present embodiment, the prescribed value may be "1," "2" or "3." Further, the prescribed value may be a value equal to or larger than "4."

In a case in which a value of the counter is smaller than the prescribed value, the controller 900 switches the one mobile holder 40A out of the two mobile holders 40A, 40B from the holding state to the releasing state (step S15). In this case, as shown in the lower field of Fig. 7, the pin 41p of the mobile holder 40A is spaced apart from the outer peripheral end of the substrate W. Therefore, no holding force is generated between the two pins 31p, 41p of the fixed holder 30A and the mobile holder 40A. At this time, the substrate W is pressed toward the fixed holder 30B by the mobile holder 40B in the holding state. Thus, as indicated by the thick dotted arrow in the lower field of Fig. 7, the substrate W moves to a position where the substrate W abuts against the fixed holder 30B, and is interposed between the two pins 31p, 41p of the fixed holder 30p and the mobile holder 40B.

Next, the controller 900 switches the one mobile holder 40A from the releasing state to the holding state (step S16). In this case, as shown in the upper field of Fig. 8, the pin 41p of the mobile holder 40A abuts against the outer peripheral end of the substrate W.

Next, the controller 900 switches the other mobile holder 40B out of the two mobile holders 40A, 40B from the holding state to the releasing state (step S17). In this case, as shown in the middle field of Fig. 8, the pin 41p of the mobile holder 40B is spaced apart from the outer peripheral end of the substrate W. Therefore, no holding force is generated between the two pins 31p, 41p of the fixed holder 30B and the mobile holder 40B. At this time, the substrate W is pressed toward the fixed holder 30A by the mobile holder 40A in the holding state. Thus, as indicated by the thick dotted arrow in the middle field of Fig. 8, the substrate W moves to a position where the substrate W abuts against the fixed holder 30A, and is interposed between the two pins 31p, 41p of the fixed holder 30A and the mobile holder 40A.

Next, the controller 900 switches the other mobile holder 40B from the releasing state to the holding state (step S18). In this case, as shown in the lower field of Fig. 8, the pin 41p of the mobile holder 40B abuts against the outer peripheral end of the substrate W. Further, the controller 900 increments a value of the counter (step S19). Thereafter, the process proceeds to the step S13.

In the above-mentioned step S14, in a case in which a value of the counter is equal to or larger than the prescribed value, the controller 900 controls the warning device 500 to cause the warning device 500 to output a warning indicating that the substrate processing apparatus 1 has an abnormality, and stops the work of the substrate processing apparatus 1 (step S21). Then, the substrate holding process ends.

### <5> Effects

In the above-mentioned substrate processing apparatus 1, with the rotation position of the spin chuck SC aligned with the reference position, the magnet lifting-lowering devices 50A, 50B can be controlled at the same time, and the magnet lifting-lowering devices 50A, 50B can be controlled individually.

In a case in which the mobile holders 40A, 40B are switched from the releasing state to the holding state at the same time, a period of time required for holding the substrate W can be shortened as compared to a case in which the mobile holders 40A, 40B are individually switched from the releasing state to the holding state.

On the other hand, in a case in which the mobile holders 40A, 40B are individually switched from the releasing state to the holding state, the pin 41p of the mobile holder 40A and the pin 41p of the mobile holder 40B sequentially abut against the outer peripheral end of the substrate W. When the mobile holder 40B abuts against the substrate W with the mobile holder 40A not abutting against the substrate W, the positioning for the substrate W by the mobile holder 40B is not affected by the abutting state of the mobile holder 40A against the substrate W. Further, when the mobile holder 40A abuts against the substrate W with the mobile holder 40B not abutting against the substrate W, the positioning for the substrate W by the mobile holder 40A is not affected by the abutting state of the mobile holder 40B against the substrate W. This can improve the reliability in regard to holding of the substrate W by the plurality of mobile holders 40A, 40B.

In the above-mentioned substrate holding process, the process of switching the mobile holders 40A, 40B from the releasing state to the holding state at the same time is executed, and then the mobile holders 40A, 40B are individually controlled based on the holding state of the substrate W. Therefore, it is possible to improve the reliability in regard to holding of the substrate W while shortening a period of time required for holding the substrate W.

### 2. Second Embodiment

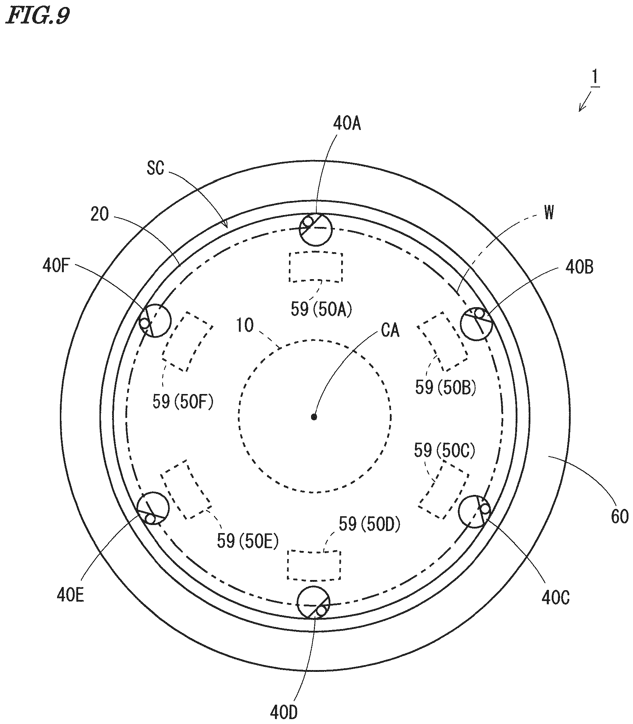

Differences of a substrate processing apparatus according to a second embodiment from the substrate processing apparatus 1 according to the first embodiment will be described. Fig. 9 is a schematic plan view of the substrate processing apparatus according to the second embodiment. The schematic plan view of Fig. 9 corresponds to the schematic plan view of Fig. 2. Therefore, also in Fig. 9, some constituent elements (constituent elements corresponding to the controller 900, the processing liquid supply device 70 and the imaging device 80 of Fig. 1) out of all of a plurality of constituent elements of the substrate processing apparatus 1 according to the second embodiment are not shown.

As shown in Fig. 9, in the substrate processing apparatus 1 according to the present embodiment, a spin chuck SC has a configuration in which six mobile holders 40A, 40B, 40C, 40D, 40E, 40F are provided at equal intervals in the peripheral portion of a spin base 20. Six magnet lifting-lowering devices 50A, 50B, 50C, 50D, 50E, 50F respectively corresponding to the six mobile holders 40A, 40B, 40C, 40D, 40E, 40F are provided below the spin base 20.

Each of the mobile holders 40A to 40F according to the present embodiment has the same configuration as that of the mobile holders 40A, 40B according to the first embodiment. The magnet lifting-lowering devices 50A to 50F also basically have the same configuration as that of the magnet lifting-lowering devices 50A, 50B according to the first embodiment. Therefore, each of the magnet lifting-lowering devices 50A to 50F has a lifting-lowering magnet 59 for switching the states of the mobile holders 40A to 40F.

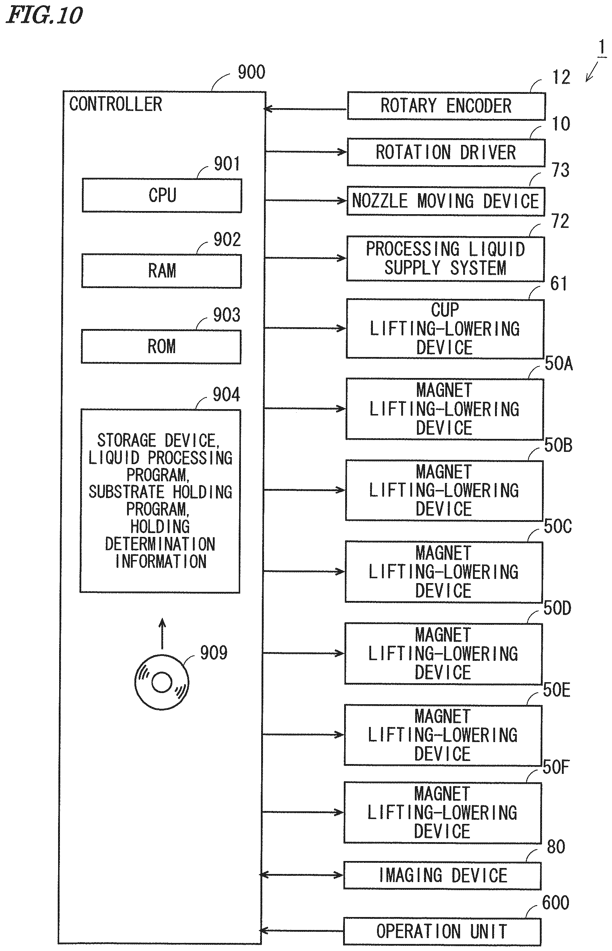

Fig. 10 is a block diagram showing a control system of the substrate processing apparatus 1 according to the second embodiment. A controller 900 according to the present embodiment can individually control the magnet lifting-lowering devices 50A to 50F. That is, the controller 900 can independently switch each of the plurality of mobile holders 40A to 40F between a holding state and a releasing state. The substrate processing apparatus 1 according to the present embodiment does not have the warning device 500. Also in the present embodiment, a storage device 904 stores a substrate holding program. A substrate holding process according to the present embodiment will be described below.

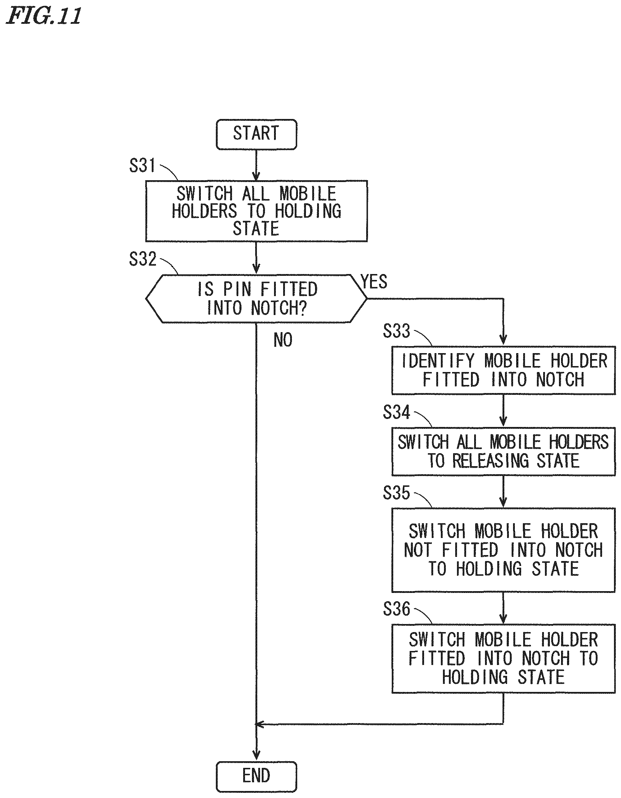

Fig. 11 is a flowchart showing one example of the substrate holding process according to the second embodiment. The series of processes described below is executed when a CPU 901 of the controller 900 executes the substrate holding program stored in the storage device 904 in response to placement of a substrate W on the spin chuck SC.

In the present embodiment, the rotation position of the spin chuck SC when the mobile holders 40A, 40B, 40C, 40D, 40E, 40F are respectively located in the vicinities of lifting-lowering magnets 59 of the magnet lifting-lowering devices 50A, 50B, 50C, 50D, 50E, 50D are referred to as a reference position.

In an initial state, the rotation position of the spin chuck SC is adjusted to the reference position. Further, each of the magnet lifting-lowering devices 50A to 50F holds the lifting-lowering magnet 59 at an upper magnet position. Thus, the mobile holders 40A to 40F are all in the releasing state. Further, the substrate W is placed on the spin chuck SC.

When the substrate holding process is started, the controller 900 switches all of the mobile holders 40A to 40F from the releasing state to the holding state by controlling the magnet lifting-lowering devices 50A to 50F (step S31). Specifically, the controller 900 lowers each of the six lifting-lowering magnets 59 of the magnet lifting-lowering devices 50A, 50B from the upper magnet position to a lower magnet position. Thus, the six mobile holders 40A to 40F are switched from the releasing state to the holding state.

During this work, pins 41p of the six mobile holders 40A to 40F move toward a center axis CA of a rotation driver 10 at the same time. Thus, the substrate W on the spin chuck SC is simultaneously positioned (centered) by the six pins 41p such that the center of the substrate W is located on the center axis CA. However, depending on the position of the substrate W in the initial state, when the one of the six pins 41p is fitted into a notch of the substrate W, the substrate W may not be accurately centered.

As such, in the present embodiment, in a case in which it is considered that the substrate W is not accurately centered, that is, a case in which one of the six pins 41p is fitted into the notch of the substrate W, the work for holding the substrate W is performed again.

Specifically, after the step S31, the controller 900 determines whether one of the six pins 41p is fitted into the notch of the substrate W (step S32). In the present embodiment, the step S32 is performed as follows, for example.

First, an image of the substrate W held on the spin chuck SC is picked up by the imaging device 80 of Fig. 1, and the image data representing the images of the substrate W and the plurality of mobile holders 40A to 40F is generated. Thereafter, based on the generated image data, whether one of the six pins 41p is fitted into the notch of the substrate W is determined.

In a case in which none of the six pins 41p is fitted into the notch of the substrate W in the step 32, the substrate holding process ends. On the other hand, when one of the six pins 41p is fitted into the notch of the substrate W, the controller 900 identifies the mobile holder fitted into the notch based on the image data generated in the step S32 (step S33).

Next, the controller 900 switches all of the mobile holders 40A to 40F from the holding state to the releasing state by controlling the magnet lifting-lowering devices 50A to 50F (step S34). Further, the controller 900 switches mobile holders that are not fitted into the notch of the substrate W from the releasing state to the holding state (step S35).

In this case, the substrate W is centered by the five pins 41p which are not affected by the notch of the substrate W, among the six pins 41p. This improves the accuracy of centering for the substrate W.

Subsequently, the controller 900 switches the one mobile holder fitted into the notch from the releasing state to the holding state (step S36). Thus, the remaining one pin 41p is fitted into the notch of the substrate W centered and held by the five pins 41p. Thus, the holding state of the substrate W is reinforced without movement of the substrate W. Thereafter, the substrate holding process ends.

Also in the substrate processing apparatus 1 according to the present embodiment, the magnet lifting-lowering devices 50A to 50F respectively corresponding to the plurality of mobile holders 40A to 40F can be individually controlled by the controller 900. Thus, when the substrate W is held by the spin chuck SC, the process of switching the mobile holders 40A to 40F from the releasing state to the holding state at the same time is executed, and then the mobile holders 40A to 40F are individually controlled based on the holding state of the substrates W. Therefore, it is possible to improve the reliability in regard to holding of the substrate W while shortening a period of time required for holding the substrate W.

### 3. Other Embodiments

(a) In the substrate holding process according to the first embodiment, the work for holding the substrate W by the common control for the mobile holders 40A, 40B (the control corresponding to the step S11 of Fig. 6) is performed. Thereafter, according to whether the substrate W is normally held, the work for holding the substrate W by the individual control for the mobile holders 40A, 40B (the control corresponding to the steps S12 to S19, and the step S21 of Fig. 6) is performed. However, the present disclosure is not limited to the above-mentioned example.

In a case in which the processing contents for the substrate W do not require appropriate holding by the four holders (30A, 30B, 40A, 40B), the work for holding the substrate W by the individual control for the mobile holders 40A, 40B does not have to be performed. That is, the steps S12 to S19 and the step S21 of Fig. 6 do not have not be performed.

On the other hand, in a case in which the processing contents for the substrate W require appropriate holding by the four holders (30A, 30B, 40A, 40B), the work for holding the substrate W by the common control for the mobile holders 40A, 40B does not have to be performed. That is, the step S11 of Fig. 6 does not have to be performed.

Therefore, according to the processing contents for the substrate W, the controller 900 may perform only one of the common control and the individual control for the mobile holders 40A, 40B (selection of control). Further, based on a user's instruction provided by the operation unit 600, the controller 900 may select and perform one of the common control and the individual control for the mobile holders 40A, 40B.

(b) Also in the substrate holding process according to the second embodiment, in a case in which the substrate W does not need to be centered with high accuracy, the work for holding the substrate W by the individual control for the mobile holders 40A to 40F (the control corresponding to the steps S32 to S36 of Fig. 11) does not have to be performed. On the other hand, in a case in which the substrate W needs to be centered with high accuracy, the work for holding the substrate W by the common control for the mobile holders 40A to 40F (the control corresponding to the step S31 of Fig. 11) does not have to be performed.

Therefore, according to the processing contents for the substrate W, the controller 900 may perform only one of the common control and the individual control for the mobile holders 40A to 40F (selection of control). Further, based on a user's instruction provided by the operation unit 600, the controller 900 may select and perform one of the common control and the individual control for the mobile holders 40A to 40B.

(c) While the two fixed holders 30A, 30B and the two mobile holders 40A, 40B are provided in the peripheral portion of the spin base 20 in the spin chuck SC in the substrate processing apparatus 1 according to the first embodiment, the present disclosure is not limited to this. All of the holders provided in the spin chuck SC may be mobile holders.

In this case, it is possible to execute the process similar to that of the example of Fig. 6 by maintaining two of the four mobile holders in the holding state during the substrate holding process.

(d) While the four holders (30A, 30B, 30C, 30D) are provided in the peripheral portion of the spin base 20 in the spin chuck SC in the substrate processing apparatus 1 according to the first embodiment, the present disclosure is not limited to this.

The spin chuck SC according to the first embodiment may have the configuration in which six holders are arranged at equal intervals in the peripheral portion of the spin base 20. In this case, two holders that are opposite to each other out of the six holders may be a fixed holder and a mobile holder, for example. Thus, by individually controlling the three mobile holders, the work for interposing the substrate W is realized for each two holders that are opposite to each other.

Alternatively, the spin chuck SC according to the first embodiment may have the configuration in which eight holders are arranged at equal intervals in the peripheral portion of the spin base 20. In this case, two holders that are opposite to each other out of the eight holders may be a fixed holder and a mobile holder, for example. Thus, by individually controlling the four mobile holders, the work for interposing the substrate W is realized for each two holders that are opposite to each other.

(e) While the six holders (40A to 40F) are provided in the peripheral portion of the spin base 20 in the spin chuck SC in the substrate processing apparatus 1 according to the second embodiment, the present disclosure is not limited to this.

The spin chuck SC according to the second embodiment may have the configuration in which four holders are arranged at equal intervals in the peripheral portion of the spin base 20. In this case, the substrate W is centered by the four holders.

Alternatively, the spin chuck SC according to the second embodiment may have the configuration in which eight holders are arranged at equal intervals in the peripheral portion of the spin base 20. In this case, the substrate W is centered by the eight holders.

(f) In the substrate processing apparatus 1 according to the second embodiment, in regard to the control in which two holders that are opposite to each other out of the six holders (40A to 40F) are set to the holding state and the other four holders out of the six holders (40A to 40F) are set to the releasing state, a set of two holders to be set to the holding state may be changed sequentially. For example, a first set includes the holders 40A, 40D that correspond to each other, a second set includes holders 40B, 40E that correspond to each other, and a third set includes holders 40C, 40F that correspond to each other. In a first stage, the two holders in the first set are set to the holding state, and the four holders included in the second set and the third set are set to the releasing state. In a second stage that follows the first stage, the two holders in the second set are set to the holding state, and the four holders included in the first set and the third set are set to the releasing state. In a third stage that follows the second stage, the two holders included in the third set are set to the holding state, and the four holders included in the first set and the second set are set to the releasing state. In a fourth stage that follows the third stage, the six holders (40A to 40F) are set to the holding state. In this case, the substrate W is centered by the six holders (40A to 40F).

(g) While a notch is formed in the substrate W to be processed by the substrate processing apparatus 1 according to the above-mentioned embodiment, the present disclosure is not limited to this. An orientation flat may be formed in the outer peripheral end of the substrate W as a cutout for positioning instead of the above-mentioned notch. Also in this case, the above-mentioned substrate holding process can be effectively utilized to suppress the problem in holding the substrate W caused by abutment of one of a plurality of holders against an orientation flat.

(h) While the substrate processing apparatus 1 according to each of the first embodiment and the second embodiment has the configuration in which the process of supplying the processing liquid to the upper surface of the substrate W held by the spin chuck SC is to be executed, the present disclosure is not limited to this. The spin chuck SC may have the configuration for holding a plurality of portions of the outer peripheral end of the substrate W from above the substrate W. In this case, the processing liquid supply device 70 may be configured to discharge the processing liquid from below the substrate W toward the lower surface of the substrate W.

(i) While the substrate processing apparatus 1 according to each of the first embodiment and the second embodiment includes the processing liquid supply device 70 as the configuration for executing a process on the substrate W held by the spin chuck SC, the present disclosure is not limited to this. The configuration for performing a process on the substrate W held by the spin chuck SC may include a device for cleaning the substrate W with a brush or may include a device for injecting gas to the substrate W.

(j) In the substrate processing apparatus 1 according to each of the first and second embodiments, the support 31 is provided as part of each of the fixed holders 30A, 30B, and the support 41 is provided as part of each of the mobile holders 40A, 40B. However, the present disclosure is not limited to this. A supporter that supports the substrate W by abutment of the spin chuck SC of the substrate processing apparatus 1 against the substrate W from below may be separately provided. In this case, the supporter is equivalent to the support of the present disclosure.

### 4. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the configuration including at least the rotation driver 10, the magnet lifting-lowering devices 50A, 50B, 50C, 50D, 50E, 50F and the spin chuck SC of the substrate processing apparatus 1 is an example of a substrate holding device, the supports 31, 41 are examples of a support, the spin base 20 is an example of a rotation member, the rotation driver 10 is an example of a rotation driver, and the mobile holders 40A, 40B, 40C, 40D, 40E, 40F are an example of a plurality of mobile holders.

Further, the magnet lifting-lowering devices 50A, 50B, 50C, 50D, 50E, 50F are examples of a state switcher, the controller 900 is an example of a controller, the control based on the step S11 of Fig. 6 and the step S31 of Fig. 11 is an example of a first control, and the control based on the steps S15 to S18 of Fig. 6 and the steps S35 and S36 of Fig. 11 is an example of a second control.

Further, the imaging device 80 and the controller 900 are examples of a state determiner, the fixed holders 30A, 30B are an example of a plurality of fixed holders, the warning device 500 is an example of a warning outputter, the processing liquid supply device 70 is an example of a processor, and the substrate processing apparatus 1 is an example of a substrate processing apparatus.

### 5. Overview of Embodiments

(Item 1) A substrate holding device according to item 1 that holds a substrate, includes a support that supports the substrate, a rotation member provided to be rotatable about an axis extending in an upward-and-downward direction, a rotation driver that rotates the rotation member about the axis, a plurality of mobile holders that are provided in a peripheral portion of the rotation member, with each mobile holder being switchable between a holding state in which the mobile holder abuts against an outer peripheral end of the substrate to hold the substrate and a releasing state in which the mobile holder is spaced apart from the outer peripheral end of the substrate, a state switcher that switches the plurality of mobile holders between the holding state and the releasing state, and a controller that selectively executes a first control and a second control with respect to the state switcher, wherein in the first control, the plurality of mobile holders are switched from the releasing state to the holding state at a same time, and in the second control, switching of part of the plurality of mobile holders from the releasing state to the holding state and switching of other mobile holders of the plurality of mobile holders from the releasing state to the holding state are executed at different points in time.

In the substrate holding device, when the plurality of mobile holders provided in the rotation member are set to the holding state, the substrate is held on the rotation member. In this state, the rotation member rotates about the axis extending in the upward-and-downward direction by the rotation driver. Thus, various processes can be executed on one surface of the rotating substrate. Further, the plurality of mobile holders are set to the releasing state with the rotation of the rotation member stopped, so that the substrate on the rotation member can be taken out from the substrate holding device.

With the above-mentioned configuration, the controller can selectively execute the first control and the second control of the state switcher. With the first control, when the substrate to be transferred to the substrate holding device is held, the plurality of mobile holders are switched at the same time from the releasing state to the holding state. This can shorten a period of time required for holding the substrate.

On the other hand, with the second control, part of the mobile holders and the other mobile holders sequentially abut against the outer peripheral end of the substrate. In this case, when the part of the mobile holders abuts against the substrate with the other mobile holders not abutting against the substrate, positioning of the substrate by the part of the mobile holders is hardly affected by the abutting state of the other mobile holders against the substrate. Further, when the other mobile holders abut against the substrate with the part of the mobile holders not abutting against the substrate, positioning of the substrate by the other mobile holders is unlikely to be affected by the abutting state of the part of the mobile holders against the substrate. This can improve the reliability of the holding of the substrate by the plurality of mobile holders.

Therefore, in a case in which the processing contents for the substrate do not require the appropriate holding of the substrate, it is possible to shorten the period of time required for holding the substrate by adopting the first control. Further, in a case in which the processing contents for the substrate require appropriate holding of the substrate, it is possible to improve the reliability in regard to holding of the substrate by adopting the second control. As a result, the substrate can be held appropriately in accordance with the processing contents for the substrate.

(Item 2) The substrate holding device according to item 1, may further includes a state determiner that, when the plurality of mobile holders are in the holding state, determines which one of a predetermined first state and a predetermined second state the substrate held by the plurality of mobile holders is in, wherein the controller, when the substrate is in the first state, may maintain the plurality of mobile holders in the holding state, and when the substrate is in the second state, may switch at least part of the plurality of mobile holders from the holding state to the releasing state and then executes the second control.

In this case, when the plurality of mobile holders are in the holding state, based on the state of the substrate, the plurality of mobile holders are maintained in the holding state, or the second control is executed by switch of part of the plurality of mobile holders to the releasing state. Thus, in a case in which the substrate is in the first state, the period of time required for holding the substrate can be shortened. Further, in a case in which the substrate is in the second state, the reliability in regard to holding of the substrate can be improved by the second control.

(Item 3) The substrate holding device according to item 2, may further include a plurality of fixed holders that are provided in the peripheral portion of the rotation member and restricts movement, outwardly of the rotation member, of the substrate held by the plurality of mobile holders in the holding state, wherein in the first state, an outer peripheral end of the substrate may be in contact with the plurality of fixed holders, and in the second state, the outer peripheral end of the substrate may be spaced apart from at least one of the plurality of fixed holders.

In this case, the substrate held by the substrate holding device is located between the plurality of fixed holders and the plurality of mobile holders. In the first state, the outer peripheral end of the substrate is in contact with the plurality of fixed holders. Therefore, the substrate is appropriately held by the plurality of fixed holders and the plurality of mobile holders. On the other hand, in the second state, the outer peripheral end of the substrate is spaced apart from at least one fixed holder. Therefore, the substrate is not held appropriately. As such, the second control is executed. This improves the reliability of the substrate holding device in regard to holding of the substrate.

(Item 4) The substrate holding device according to item 3, wherein each fixed holder may be arranged to be opposite to one of the plurality of mobile holders with a center portion of the rotation member interposed between the fixed holder and the one of the plurality of mobile holders, and when being in the holding state, each mobile holder may press the substrate toward a fixed holder arranged to be opposite to the mobile holder.

In this case, the substrate pressed by each mobile holder abuts against the fixed holder opposite to the mobile holder. In this state, the movement of the substrate from the mobile holder to the fixed holder opposite to the mobile holder is restricted. This can improve the accuracy in regard to a position at which the substrate is held on the rotation member.

(Item 5) The substrate holding device according to any one of items 2 to 4, wherein in the first state, the substrate may be located at a predetermined position with respect to the rotation member, and in the second state, the substrate may be not located at the predetermined position with respect to the rotation member.

In this case, whether the holding state of the substrate is maintained or the second control is executed is selected in accordance with the position of the substrate with respect to the rotation member. Therefore, the position of the substrate with respect to the rotation member when the substrate is appropriately held by the substrate holder is the above-mentioned predetermined position, so that the reliability of the substrate holding device in regard to holding of the substrate is improved.

(Item 6) The substrate holding device according to any one of items 2 to 5, may further include a warning outputter that outputs a warning, wherein the controller may cause the warning outputter to output a warning in a case in which the state determiner successively determines, a predetermined number of times, that the substrate is in the second state.

In this case, the user can easily identify that there is an abnormality in the work of the substrate holding device based on the warning output from the warning outputter.

(Item 7) The substrate holding device according to any one of items 1 to 6, wherein the controller may execute the first control when the plurality of mobile holders are in the releasing state and the substrate is arranged among the plurality of mobile holders.

In this case, when the substrate is transferred to the substrate holding device, the substrate is held by the plurality of mobile holders in a short period of time.

(Item 8) A substrate processing apparatus according to item 8 includes the substrate holding device according to any one of items 1 to 7 that holds a substrate, and a processor that executes a predetermined process on the substrate held and rotated by the substrate holding device.

The substrate processing apparatus includes the above-mentioned substrate holding device. Thus, the method of holding the substrate is appropriately selected in accordance with the processing contents for the substrate. Thus, with the first control, the period of time required for holding the substrate can be shortened. Therefore, the throughput of a substrate process in the substrate processing apparatus is improved. Further, with the second control, the substrate is held with high reliability by the substrate holding device during the substrate process. This prevents the substrate from being detached from the substrate holding device at an unintended point in time during the substrate process.

(Item 9) A substrate holding device according to item 9 that holds a substrate, includes a support that supports the substrate, a rotation member provided to be rotatable about an axis extending in an upward-and-downward direction, a rotation driver that rotates the rotation member about the axis, a plurality of mobile holders that are provided in a peripheral portion of the rotation member, with each mobile holder being switchable between a holding state in which the mobile holder abuts against an outer peripheral end of the substrate to hold the substrate and a releasing state in which the mobile holder is spaced apart from the outer peripheral end of the substrate, a state switcher that switches the plurality of mobile holders between the holding state and the releasing state, and a controller that controls the state switcher, wherein with the substrate supported by the support, the controller switches part of the plurality of mobile holders from the releasing state to the holding state and switches other mobile holders out of the plurality of mobile holders from the releasing state to the holding state at different points in time.

With the above-mentioned configuration, part of the mobile holders and the other mobile holders sequentially abut against the outer peripheral end of the substrate. In this case, when the part of the mobile holders abuts against the substrate with the other mobile holders not abutting against the substrate, positioning of the substrate by the part of the mobile holders is hardly affected by the abutting state of the other mobile holders against the substrate. Further, when the other mobile holders abut against the substrate with the part of the mobile holders not abutting against the substrate, positioning of the substrate by the other mobile holders is unlikely to be affected by the abutting state of the part of the mobile holders against the substrate. This can improve the reliability in regard to the holding of the substrate by the plurality of mobile holders.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

## Claims

1. A substrate holding device that holds a substrate, comprising:
a support that supports the substrate;
a rotation member provided to be rotatable about an axis extending in an upward-and-downward direction;
a rotation driver that rotates the rotation member about the axis;
a plurality of mobile holders that are provided in a peripheral portion of the rotation member, with each mobile holder being switchable between a holding state in which the mobile holder abuts against an outer peripheral end of the substrate to hold the substrate and a releasing state in which the mobile holder is spaced apart from the outer peripheral end of the substrate;
a state switcher that switches the plurality of mobile holders between the holding state and the releasing state; and
a controller that selectively executes a first control and a second control with respect to the state switcher, wherein
in the first control, the plurality of mobile holders are switched from the releasing state to the holding state at a same time, and
in the second control, switching of part of the plurality of mobile holders from the releasing state to the holding state and switching of other mobile holders of the plurality of mobile holders from the releasing state to the holding state are executed at different points in time.

2. The substrate holding device according to claim 1, further comprising a state determiner that, when the plurality of mobile holders are in the holding state, determines which one of a predetermined first state and a predetermined second state the substrate held by the plurality of mobile holders is in, wherein
the controller,
when the substrate is in the first state, maintains the plurality of mobile holders in the holding state, and
when the substrate is in the second state, switches at least part of the plurality of mobile holders from the holding state to the releasing state and then executes the second control.

3. The substrate holding device according to claim 2, further comprising a plurality of fixed holders that are provided in the peripheral portion of the rotation member and restricts movement, outwardly of the rotation member, of the substrate held by the plurality of mobile holders in the holding state, wherein
in the first state, an outer peripheral end of the substrate is in contact with the plurality of fixed holders, and
in the second state, the outer peripheral end of the substrate is spaced apart from at least one of the plurality of fixed holders.

4. The substrate holding device according to claim 3, wherein
each fixed holder is arranged to be opposite to one of the plurality of mobile holders with a center portion of the rotation member interposed between the fixed holder and the one of the plurality of mobile holders, and
when being in the holding state, each mobile holder presses the substrate toward a fixed holder arranged to be opposite to the mobile holder.

5. The substrate holding device according to any one of claims 2 to 4, wherein in the first state, the substrate is located at a predetermined position with respect to the rotation member, and
in the second state, the substrate is not located at the predetermined position with respect to the rotation member.

6. The substrate holding device according to any one of claims 2 to 5, further comprising a warning outputter that outputs a warning, wherein
the controller causes the warning outputter to output a warning in a case in which the state determiner successively determines, a predetermined number of times, that the substrate is in the second state.

7. The substrate holding device according to any one of claims 1 to 6, wherein the controller executes the first control when the plurality of mobile holders are in the releasing state and the substrate is arranged among the plurality of mobile holders.

8. A substrate processing apparatus comprising:
the substrate holding device according to any one of claims 1 to 7 that holds a substrate; and
a processor that executes a predetermined process on the substrate held and rotated by the substrate holding device.
